# EUROPÄISCHE PATENTSCHRIFT

(11) **EP 0 653 122 B1**
(45) Veröffentlichungstag und Bekanntmachung des Hinweises auf die Patenterteilung: **25.09.1996**
(21) Anmeldenummer: 93914610.6
(22) Anmeldetag: 08.07.1993
(51) Int. Cl.: H03K 17/62, H03K 17/04, G06F 13/40

(54) **ANSTEUERUNG EINES SYMMETRISCHEN BIPOLARTRANSISTORS**
CONTROL OF A SYMMETRICAL BIPOLAR TRANSISTOR
EXCITATION D'UN TRANSISTOR BIPOLAIRE SYMETRIQUE

(30) Priorität: 31.07.1992 DE 4225455
(43) Veröffentlichungstag der Anmeldung: 17.05.1995
(73) Patentinhaber: SIEMENS AKTIENGESELLSCHAFT, 80333 München (DE)
(72) Erfinder: ZIERHUT, Hermann, D-81739 München (DE)
(86) Internationale Anmeldenummer: DE9300605
(87) Internationale Veröffentlichungsnummer: WO9403975

(56) Entgegenhaltungen:
- EP-A- 0 487 759
- DE-B- 2 333 191

## Beschreibung

Für symmetrische bipolare Transistoren kann man sich viele Anwendungsfälle vorstellen. Bei einem bekannten Anwendungsfall dient ein Bipolartransistor als Verpolungsschutzelement in der Ankopplungsschaltung an ein Bussystem (EP-A-0487 759, FIG 3). Ein derartiger Verpolschutz eignet sich insbesondere für Baugruppen bei Bussystemen, bei Rechnern und bei speicherbaren Steuerungen. Das Verpolungsschutzelement liegt in einem Signalankopplungspfad als steuerbares Element, das in Abhängigkeit von der Polarität des elektrischen Signals den Signalankopplungspfad sperrt bzw. freigibt. Der bekannte Bipolartransistor ist als Doppel-Emitter-Transistor ausgeführt, dessen Emitterstrom in beide Richtungen gleichmäßig gesteuert werden kann.

Eine bipolare Transistorstruktur eignet sich andererseits allgemein dazu, zu prüfen, ob eine Potentialdifferenz einen bestimmten Wert unterschreitet und somit auch, ob eine Spannung sich einer anderen Spannung annähert. Bisher wurden Komperatoren eingesetzt. Die erforderlichen Komperatoranordnungen sind üblicherweise jedoch ziemlich aufwendig. Auf eine bipolare Transistorstruktur richtet sich eine nationale deutsche Anmeldung mit älterem Zeitrang (DE-A-43 16 608).

Inbesondere wenn eine bipolare Transistorstruktur in einem IC-Kreis integriert werden soll, ist es wünschenswert, wenn möglichst niedrige Verlustleistungen auftreten und die Ansteuerströme entsprechend niedrig sind. Der Erfindung liegt die Aufgabe zugrunde, eine Ansteuerung für einen symmetrischen bipolaren Transistor bzw. für eine bipolare Transistorstruktur in einem IC-Kreis zu finden, die mit möglichst niedrigen Ansteuerströmen auskommt.

Die Lösung der geschilderten Aufgabe besteht in einer Ansteuerung nach Patentanspruch 1. An den beiden Arbeitselektroden des symmetrischen bipolaren Transistors bzw. der symmetrischen bipolaren Transistorstruktur ist eine Stromspiegelschaltung an sich bekannter Art angeschlossen. Sie kann insbesondere mit ihrem Emitter angeschlossen sein. Die beiden Stromspiegelschaltungen sind hierbei mit ihren Basen miteinander verbunden und ihre Kollektoren arbeiten auf inverse Stromspiegel, die den zur Steuerung des bipolaren Transistors erforderlichen Steuerstrom liefern. Bei einer derartigen Anordnung kommt man mit niedrigen Ansteuerströmen für den symmetrischen bipolaren Transistor bzw. die symmetrische bipolare Transistorstruktur aus. Nachstehend werden beide Anordnungen kurz Bipolartransistor genannt.

Die Stromspiegelschaltungen können jeweils als erste Stromspiegelschaltungen um eine zweite verstärkende Stromspiegelschaltung erweitert werden, die jeweils an der Basis der ersten Stromspiegelschaltung angeschlossen sind. Eine derartige Anordnung ermöglicht es, über den Bipolartransistor Stromimpulse mit sehr hoher Flankensteilheit zu senden.

Es ist günstig, die zweiten, verstärkenden Stromspiegelschaltungen über gekoppelte ENABLE-Schalter mit den ersten Stromspiegelschaltungen zu verbinden. Die Kollektoren der ersten Stromspiegelschaltungen wirken hierbei über die ENABLE-Schalter auf je einen verstärkenden Stromspiegel. Je ein verstärkender Stromspiegel ist direkt an der Basis eines ersten Stromspiegels angeschlossen, gegegenenfalls unter Zwischenschaltung eines ENABLE-Schalters. Eine derartige Zusatzansteuerung arbeitet sehr schnell, bei einer Regelverzögerung von lediglich einigen 100 nS. Wegen des erhöhten Strombedarfs ist es jedoch günstig, die verstärkenden Stromspiegel nur im Sendefall über die ENABLE-Schalter zuzuschalten.

Die Erfindung soll nun anhand von in der Zeichnung grob schematisch wiedergegebenen Ausführungsbeispielen näher erläutert werden:
- In FIG 1: ist eine Ansteuerung für einen Bipolartransistor durch je einen Stromspiegel und nachgeschalteten inversen Stromspiegel wiedergegeben.
- In FIG 2: ist eine Ansteuerung für einen Bipolartransistor wiedergegeben, die mit zwei Sätzen von Stromspiegeln nach FIG 1 und jeweils einer verstärkenden zweiten Stromspiegelschaltung arbeitet.
- In FIG 3: ist ein anderes Schaltbild für eine einzelne Stromspiegelanordnung veranschaulicht.
- In FIG 4: ist die klassische Darstellung einer DARLINGTON-schaltung für Transistoren dargestellt.

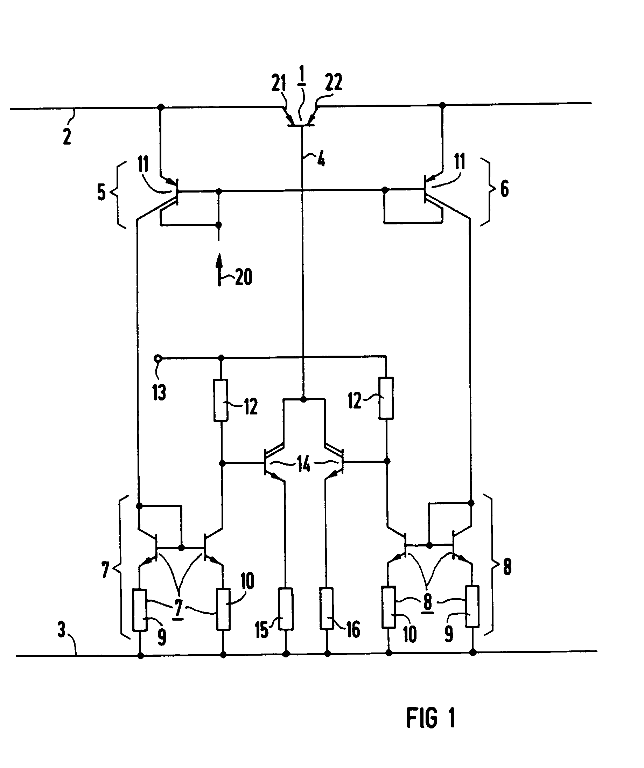

Der Bipolartransistor 1 nach FIG 1 ist als Doppel-Emitter-Transistor ausgeführt. Er ist in einer Leitung 2 einer Leiteranordnung aus den Leitungen 2 und 3 mit seinen Arbeitselektroden, den Emitterelektroden eingeschaltet. Ein Anschluß 4 führt zur Basis des Bipolartransistors. An den Emittern des als Doppel-Emitter-Transistor ausgeführten Bipolartransitors sind jeweils erste Stromspiegelschaltungen 5 und 6 angeschlossen. Diese sind mit ihren Basisanschlüssen miteinander verbunden. Je ein Kollektor 11 der miteinander verknüpften ersten Stromspiegelschaltungen 5 bzw. 6 arbeitet auf eine inverse Stromspiegelschaltung 7 bzw. 8. Die Widerstände 9 und gegebenenfalls die Widerstände 10 sind wahlweise vorgesehen, um bei einer einstellbaren Spiegelkennlinie die Übertragungsverhältnisse, wie sie aufgrund der IC-Flächen der Stromspiegelschaltungen gegeben sind, zu modifizieren.

Die Ausgänge der inversen Stromspiegelschaltungen sind jeweils mit einem Widerstand 12 verbunden, die von einer Konstantspannungsquelle 13 bezüglich Erde gespeist werden. Die Ausgänge der inversen Stromspiegelschaltungen 7 und 8 arbeiten weiter auf jeweils eine Basis eines Transistors 14, beispielsweise in DARLINGTON-Schaltung. Die Transistoren 14 sind ihrerseits mit ihren Kollektoren an der Basis als Steuerelektrode des Bipolartransistors angeschlossen. Die Widerstände 15 und 16 dienen der Linearisierung und Strombegrenzung.

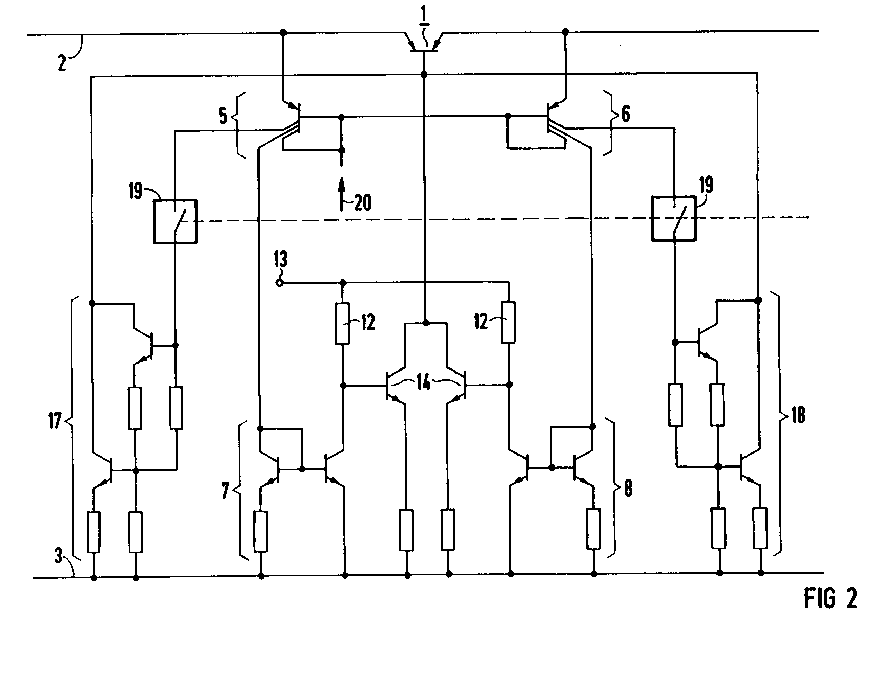

In der Ausführung nach FIG 2 sind im Prinzip an eine Schaltungsanordnung nach FIG 1 jeweils zweite verstärkende Stromspiegelschaltungen 17 und 18 über ENABLE-Schalter 19 angeschlossen, die jeweils an einem weiteren Kollektor der ersten Stromspiegelschaltung 5 bzw. 6 angeschlossen sind. Eine Bezugsspannung ist wieder als Konstantspannungsquelle 13 angeschlossen und eine Bezugsstromquelle 20 speist wieder die ersten Stromspiegelschaltungen 5 und 6.

### Die Schaltung nach FIG 1 arbeitet wie folgt:

Der Erregerstrom 20 aus einer eingeprägten Stromquelle teilt sich auf die Stromspiegelwaage aus den ersten Stromspiegelschaltungen 5 und 6 auf, und zwar je nachdem, ob die Arbeitselektrode 21 oder die Arbeitselektrode 22 des Bipolartransistors 1 positiveres Potential aufweist. Ist das Potential an der Arbeitselektrode 21 positiver als das an der Arbeitselektrode 22, so zieht die erste Stromspiegelschaltung 5 mehr Strom als die erste andere Stromspiegelschaltung 6. Anderenfalls sind die Verhältnisse umgekehrt.

Ist der Bipolartransistor 1 voll in Sättigung, so daß die Potentiale an den Arbeitselektroden 21 und 22 gleich sind, teilt sich der Erregerstrom 20 gleichmäßig auf die ersten Stromspiegelschaltungen 5 und 6 auf. Die Stromspiegelwaage ist dann im Gleichgewicht. In diesem Fall ziehen die beiden inversen Stromspiegelschaltungen 7 und 8 den gleichen Strom. Die Widerstände 12 sind so dimensioniert, daß im geschilderten Zustand an jedem der gleich Spannungsfall auftritt. Dieser Spannungsfall entspricht bzw. ist gleich der Spannung aus der Konstantspannungsquelle 13. Dadurch liegen die Basen der im Ausführungsbeispiel als DARLINGTON-Transistoren wiedergegebenen Transistoren 14 auf Masse, so daß in ihre Kollektoren kein Strom aus der Steuerelektrode des Bipolartransistors 1, über den Anschluß 4, fließen kann.

Der Ansteuerstrom steigt erst an, wenn die Waage aus den ersten Stromspiegelschaltungen 5 und 6 nicht mehr im Gleichgewicht ist. In Abhängigkeit von der Richtung eines Stromes über den Bipolartransitor 1 wird die Arbeitselektrode 21 oder 22 negativer, so daß einer der beiden Transistoren 14 eine positive Ansteuerung erhält und dadurch den Bipolartransistor 1 den erforderlich Ansteuerstrom liefert.

In der Schaltungsanordnung nach FIG 2 wirken die Kollektoren der ersten Stromspiegelschaltungen 5 bzw. 6, die über ENABLE-Schalter 19 geführt sind, auf je eine verstärkende Stromspiegelschaltung 17 bzw. 18. Diese Zusatzansteuerung arbeitet sehr schnell, in der Praxis bei einer Regelverzögerung von einigen 100 nS. Daß die verstärkenden zweiten Stromspiegelschaltungen 17 und 18 an sich einen größeren Strombedarf haben, läßt sich durch die ENABLE-Schalter 19 beheben. Es ist günstig, die Zuschaltung über die ENABLE-Schalter 19 nur im Sendefall vorzunehmen.

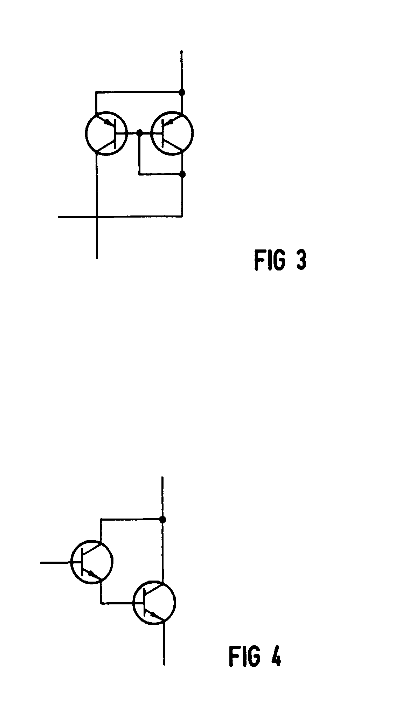

In FIG 3 ist eine andere Darstellungsweise der ersten Stromspiegelschaltungen 5 bzw. 6 wiedergegeben. Diese Darstellungsweise war früher geläufiger. In FIG 4 ist für die in FIG 1 beispielsweise als DARLINGTON-Transistoren wiedergegebenen Transistoren 14 eine klassische Darstellungsart wiedergegeben.

## Patentansprüche

1. Ansteuerung für einen symmetrischen Bipolartransistor (1) bzw. für eine symmetrische bipolare Transistorstruktur,
**dadurch gekennzeichnet,**
daß an den beiden Arbeitselektroden (21, 22) jeweils eine Stromspiegelschaltung (5; 6) angeschlossen ist, wobei die beiden Stromspiegelschaltungen (5; 6) mit ihren Basen miteinander verbunden sind und ihre Kollektoren auf inverse Stromspiegelschaltungen (7; 8) arbeiten, die einen Schalter (14) ansteuern, über den der vom Bipolartransistor benötigte Basisstrom fließt, wobei der Schalter (14) keinen Basisstrom liefert, wenn die beiden Arbeitselektroden des symmetrischen Bipolartransistors auf gleichem Potential liegen, und wobei den Basisanschlüssen der ersten Stromspiegelschaltungen (5, 6) ein Referenzstrom (Erregerstrom 20) zugeführt wird.

2. Ansteuerung nach Anspruch 1,
**dadurch gekennzeichnet,**
daß die Stromspiegelschaltungen jeweils als erste Stromspiegelschaltungen (5; 6) um eine zweite verstärkende Stromspiegelschaltung (17; 18) erweitert sind, die jeweils an einem weiteren Kollektor der ersten Stromspiegelschaltung (5; 6) angeschlossen sind.

3. Ansteuerung nach Anspruch 2,
**dadurch gekennzeichnet,**
daß die zweiten, verstärkenden Stromspiegelschaltungen (17, 18) über gekoppelte ENABLE-Schalter (19) mit den ersten Stromspiegelschaltungen (5; 6) verbunden sind.

## Claims

1. Driving control for a symmetrical bipolar transistor (1) or for a symmetrical bipolar transistor structure, characterised in that connected to the two working electrodes (21, 22) there is a respective current-mirror circuit arrangement (5; 6), wherein the two current-mirror circuit arrangements (5; 6) are connected together by means of their bases, and their collectors operate into inverse current-mirror circuit arrangements (7; 8), which activate a switch (14) via which there flows the base current that is required by the bipolar transistor, wherein the switch (14) does not deliver a base current if the two working electrodes of the symmetrical bipolar transistor are at the same potential and wherein a reference current (excitation current 20) is supplied to the base terminals of the first current-mirror circuit arrangements (5, 6).

2. Driving control according to claim 1, characterised in that the current-mirror circuit arrangements as first current-mirror circuit arrangements (5; 6) are each extended by a second amplifying current-mirror circuit arrangement (17; 18), which second current-mirror circuit arrangements are each connected to a further collector of the first current-mirror circuit arrangement (5; 6).

3. Driving control according to claim 2, characterised in that the second amplifying current-mirror circuit arrangements (17, 18) are connected to the first current-mirror circuit arrangements (5; 6) by way of coupled ENABLE switches (19).

## Revendications

1. Commande d'un transistor (1) bipolaire symétrique ou d'une structure de transistor bipolaire symétrique,
caractérisée en ce que
il est connecté à chacune des deux électrodes (21, 22) de travail un circuit (5 ; 6) de miroir de courant, les deux circuits (5 ; 6) de miroir de courant étant reliés l'un à l'autre par leur base et leurs collecteurs fonctionnant sur des circuits (7 ; 8) inverse de miroir de courant commandant un interrupteur (14) , par lequel le courant de base nécessaire au transistor bipolaire passe, l'interrupteur (14) ne fournissant pas de courant de base, lorsque les deux électrodes de travail du transistor bipolaire symétrique sont au même potentiel et un courant de référence (courant d'excitation 20) étant envoyé aux bornes de base des premiers circuits (5, 6) de miroir de courant.

2. Commande suivant la revendication 1,
caractérisée en ce que
les circuits de miroir de courant sont complétés chacun, en tant que premiers circuits (5 ; 6) de miroir de courant, par un second circuit (17 ; 18) amplificateur de miroir de courant, les seconds circuits amplificateurs de miroir de courant étant chacun connecté à un autre collecteur du premier circuit (5 ; 6) de miroir de courant.

3. Commande suivant la revendication 2,
caractérisée en ce que,
les seconds circuits (17, 18) amplificateurs de miroir de courant sont reliés par l'intermédiaire d'interrupteurs (19) couplés de validation aux premiers circuits (5, 6) de miroir de courant.
